(19) Europäisches Patentamt
European Patent Office
Office européen des brevets

(11) **EP 4 216 098 A1**

(12) **EUROPEAN PATENT APPLICATION**
published in accordance with Art. 153(4) EPC

(43) Date of publication:
**26.07.2023 Bulletin 2023/30**

(51) International Patent Classification (IPC):
**G06F 30/27** (2020.01)

(21) Application number: **21920563.0**

(22) Date of filing: **30.07.2021**

(86) International application number:
**PCT/CN2021/109534**

(87) International publication number:
**WO 2022/156182 (28.07.2022 Gazette 2022/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.01.2021 CN 202110092643**

(71) Applicant: **Momenta (Suzhou) Technology Co., Ltd.**
**Suzhou, Jiangsu 215133 (CN)**

(72) Inventors:
• **XIAO, Zhuoyue**
  **Suzhou Jiangsu 215133 (CN)**
• **XU, Mengen**
  **Suzhou Jiangsu 215133 (CN)**
• **XU, Zizhe**
  **Suzhou Jiangsu 215133 (CN)**
• **LIANG, Jiannan**
  **Suzhou Jiangsu 215133 (CN)**
• **ZHOU, Mofan**
  **Suzhou Jiangsu 215133 (CN)**
• **FU, Zhiqiang**
  **Suzhou Jiangsu 215133 (CN)**
• **YAN, Ruihui**
  **Suzhou Jiangsu 215133 (CN)**

(74) Representative: **Ipey**
**Apex House**
**Thomas Street**
**Trethomas**
**Caerphilly CF83 8DP (GB)**

(54) **METHODS AND APPARATUSES FOR CONSTRUCTING VEHICLE DYNAMICS MODEL AND FOR PREDICTING VEHICLE STATE INFORMATION**

(57)     An embodiment of the present disclosure provides a method and an apparatus for constructing a vehicle dynamics model and a method and an apparatus for predicting vehicle state information. The method of constructing a vehicle dynamics model includes: obtaining sample historical state information and a sample control parameter sequence corresponding to each sample time of a target vehicle and label vehicle state information of each sample time; for each sample time, inputting the sample historical state information and the sample control parameter sequence corresponding to the sample time into an initial vehicle dynamics model to determine sample prediction state information; by using the sample prediction state information and the label vehicle state information, determining a current loss value; based on the current loss value, adjusting model parameters of the initial vehicle dynamics model until the initial vehicle dynamics model reaches a preset convergence state so as to obtain a pre-constructed vehicle dynamics model. In this way, a vehicle dynamics model more fit for the vehicle can be constructed.

FIG.1

**Description**

**TECHNICAL FIELD**

The present disclosure relates to the field of self driving technologies, and in particular to a method and an apparatus for constructing a vehicle dynamics model and a method and an apparatus for predicting vehicle state information.

**BACKGROUND**

In the self driving field, self driving vehicles usually acquire, by prediction, vehicle state information based on a pre-constructed vehicle dynamics model so as to complete self driving. Correspondingly, accuracy of a prediction result of the pre-constructed vehicle dynamics model has great impact on safety of the self driving vehicles.

At present, a simulation software CarSim is generally used to construct a vehicle dynamics model of a vehicle through simulation. When the vehicle dynamics model of the vehicle is constructed by using the simulation software CarSim, a user needs to know details about characteristic parameters and working conditions of each system of the vehicle. For the simulation industry in the self driving field, in most cases, the specific characteristic parameters of each system of the vehicles cannot be obtained from vehicle manufacturers and part suppliers. In this case, it is required to carry out heuristic parameter adjustment continuously to continuously reduce errors between simulation and true vehicle dynamics.

In addition, even if the characteristic parameters of each system of the vehicle can be obtained during construction of the vehicle dynamics model of the vehicle, due to factors such as manufacturing process and part loss of the vehicle and the like, there may be some errors between the true vehicle and a mathematical model-derived vehicle dynamics model constructed by using the simulation software CarSim.

**SUMMARY**

The present disclosure provides a method and an apparatus for constructing a vehicle dynamics model and a method and an apparatus for predicting vehicle state information, so as to construct a vehicle dynamics model more fit for a vehicle, and further determine accurate vehicle state information. The specific technical solution is described below.

According to a first aspect of embodiments of the present disclosure, there is provided a method of constructing a vehicle dynamics model, including:

obtaining sample historical state information and a sample control parameter sequence corresponding to each sample time of a target vehicle and label vehicle state information of each sample time, where the sample control parameter sequence corresponding to each sample time includes control parameters of the sample time and each time within an advanced first time length;

for each sample time, inputting the sample historical state information and the sample control parameter sequence corresponding to the sample time into an initial vehicle dynamics model to determine sample prediction state information corresponding to the sample time;

for each sample time, by using the sample prediction state information corresponding to the sample time and the label vehicle state information of the sample time, determining a current loss value corresponding to the initial vehicle dynamics model;

based on the current loss value, adjusting model parameters of the initial vehicle dynamics model until the initial vehicle dynamics model reaches a preset convergence state so as to obtain a pre-constructed vehicle dynamics model.

Optionally, the sample historical state information corresponding to the sample time is vehicle state information of the target vehicle at a time corresponding to an advanced second time length of the sample time, where the second time length is less than the first time length.

Optionally, for each sample time, inputting the sample historical state information and the sample control parameter sequence corresponding to the sample time into the initial vehicle dynamics model to determine the sample prediction state information corresponding to the sample time includes:

for each sample time, inputting the sample historical state information corresponding to the sample time into a feature coding layer of the initial vehicle dynamics model to obtain an implicit vector corresponding to the sample historical state information corresponding to the sample time;

for each sample time, inputting the implicit vector corresponding to the sample historical state information corresponding to the sample time and the sample control parameter sequence corresponding to the sample time into a state recurrent prediction layer of the initial vehicle dynamics model to obtain an implicit vector corresponding to the vehicle state information corresponding to the sample time;

for each sample time, inputting the implicit vector corresponding to the vehicle state information corresponding to the sample time into a feature decoding layer of the initial vehicle dynamics model to determine the sample prediction state information corresponding to the sample time.

Optionally, after the step of obtaining the pre-constructed vehicle dynamics model when determining the initial vehicle dynamics model converges, the method further includes:

    obtaining raw test data of the target vehicle, where the raw test data includes: test historical state information, a test control parameter sequence and test vehicle state information corresponding to each test time generated during a travel process of the target vehicle, the test control parameter sequence corresponding to each test time includes: control parameters of the test time and each time within the advanced first time length, and the test historical state information corresponding to the test time is: vehicle state information of a time corresponding to the advanced second time length of the test time;

    inputting test historical state information and a test control parameter sequence corresponding to a first test time into the pre-constructed vehicle dynamics model to determine test prediction state information corresponding to the first test time, where the first test time includes an earliest test time and each time prior to the time corresponding to the second time length after the earliest test time;

    inputting prediction historical state information and a test control parameter sequence corresponding to a second test time into the pre-constructed vehicle dynamics model to determine test prediction state information corresponding to the second test time, where the second test time is a time other than the first test time in the test times, and the prediction historical state information corresponding to the second test time is test prediction state information corresponding to a time corresponding to the advanced second time length of the second test time;

    by using the test prediction state information and the test vehicle state information corresponding to each test time, determining a test result of the pre-constructed vehicle dynamics model.

According to a second aspect of embodiments of the present disclosure, there is provided a method of predicting vehicle state information, including:

    obtaining historical state information and current control parameter sequence corresponding to a target vehicle at a current time, where the current control parameter sequence includes: control parameters of the current time and each time within an advanced first time length;

    inputting the historical state information and the current control parameter sequence into a pre-constructed vehicle dynamics model to determine vehicle state information of the target vehicle at the current time, where the pre-constructed vehicle dynamics model is a recurrent neural network model obtained by training based on sample state information and sample control parameter sequence corresponding to each historical time of the target vehicle.

Optionally, the historical state information is vehicle state information of the target vehicle at a time corresponding to an advanced second time length of the current time, and the second time length is less than the first time length.

Optionally, inputting the historical state information and the current control parameter sequence into the pre-constructed vehicle dynamics model to determine the vehicle state information of the target vehicle at the current time includes:

    inputting the historical state information into a feature coding layer of the pre-constructed vehicle dynamics model to obtain an implicit vector corresponding to the historical state information;

    inputting the implicit vector corresponding to the historical state information and the current control parameter sequence into a state recurrent prediction layer of the pre-constructed vehicle dynamics model to obtain an implicit vector corresponding to the vehicle state information corresponding to the current time;

    inputting the implicit vector corresponding to the vehicle state information corresponding to the current time into a feature decoding layer of the pre-constructed vehicle dynamics model to obtain the vehicle state information corresponding to the current time.

Optionally, the method further includes:

    obtaining current control parameters determined by a preset control parameter determining model based on the vehicle state information of the current time;

    inputting a target control parameter sequence including the current control parameters and historical state information corresponding to a next time of the current time into the pre-constructed vehicle dynamics model to determine vehicle state information of the target vehicle at the next time of the current time, where the target control parameter sequence further includes: control parameters of various times between the current time and a previous time of a time corresponding to the advanced first time length.

According to a third aspect of embodiments of the present disclosure, there is provided an apparatus for constructing a vehicle dynamics model, including:

    a first obtaining module, configured to obtain sample historical state information and a sample control parameter sequence corresponding to each sample time of a target vehicle and label vehicle state information of each sample time, where the sample control parameter sequence corresponding to each sample time includes control parameters of the sample time and each time within an advanced first time length;

a first determining module, configured to, for each sample time, input the sample historical state information and the sample control parameter sequence corresponding to the sample time into an initial vehicle dynamics model to determine sample prediction state information corresponding to the sample time;

a second determining module, configured to, for each sample time, by using the sample prediction state information corresponding to the sample time and the label vehicle state information of the sample time, determine a current loss value corresponding to the initial vehicle dynamics model;

an adjusting module, configured to, based on the current loss value, adjust model parameters of the initial vehicle dynamics model until the initial vehicle dynamics model reaches a preset convergence state, so as to obtain a pre-constructed vehicle dynamics model.

Optionally, the sample historical state information corresponding to the sample time is state information of the target vehicle at a time corresponding to an advanced second time length of the sample time, where the second time length is less than the first time length.

Optionally, the first determining module is specifically configured to: for each sample time, input the sample historical state information corresponding to the sample time into a feature coding layer of the initial vehicle dynamics model to obtain an implicit vector corresponding to the sample historical state information corresponding to the sample time;

for each sample time, input the implicit vector corresponding to the sample historical state information corresponding to the sample time and the sample control parameter sequence corresponding to the sample time into a state recurrent prediction layer of the initial vehicle dynamics model to obtain an implicit vector corresponding to the vehicle state information corresponding to the sample time;

for each sample time, input the implicit vector corresponding to the vehicle state information corresponding to the sample time into a feature decoding layer of the initial vehicle dynamics model to determine the sample prediction state information corresponding to the sample time.

Optionally, the apparatus further includes:

a second obtaining module, configured to: after obtaining the pre-constructed vehicle dynamics model when determining the initial vehicle dynamics model converges, obtain raw test data of the target vehicle, where the raw test data includes: test historical state information, a test control parameter sequence and test vehicle state information corresponding to each test time generated during a travel process of the target vehicle, the test control parameter sequence corresponding to each test time includes: control parameters of the test time and each time within the advanced first time length, and the test historical state information corresponding to the test time is: vehicle state information of a time corresponding to the advanced second time length of the test time;

a fourth determining module, configured to input test historical state information and a test control parameter sequence corresponding to a first test time into the pre-constructed vehicle dynamics model to determine test prediction state information corresponding to the first test time, wherein the first test time includes an earliest test time and each time prior to the time corresponding to the second time length after the earliest test time;

a fifth determining module, configured to input prediction historical state information and a test control parameter sequence corresponding to a second test time into the pre-constructed vehicle dynamics model to determine test prediction state information corresponding to the second test time, where the second test time is a time other than the first test time in the test times, and the prediction historical state information corresponding to the second test time is test prediction state information corresponding to a time corresponding to the advanced second time length of the second test time;

a sixth determining module, configured to, by using the test prediction state information and the test vehicle state information corresponding to each test time, determine a test result of the pre-constructed vehicle dynamics model.

According to a fourth aspect of embodiments of the present disclosure, there is provided an apparatus for predicting vehicle state information, including:

a third obtaining module, configured to obtain historical state information and current control parameter sequence corresponding to a target vehicle at a current time, where the current control parameter sequence includes: control parameters of the current time and each time within an advanced first time length;

a seventh determining module, configured to input the historical state information and the current control parameter sequence into a pre-constructed vehicle dynamics model to determine vehicle state information of the target vehicle at the current time, where the pre-constructed vehicle dynamics model is a recurrent neural network model obtained by training based on sample state information and sample control parameter sequence corresponding to each historical time of the target vehicle.

Optionally, the historical state information is vehicle state information of the target vehicle at a time corresponding to an advanced second time length of the current time, and the second time length is less than the first time length.

Optionally, the seventh determining module is specifically configured to: input the historical state information into a feature coding layer of the pre-constructed vehicle dynamics model to obtain an implicit vector corresponding to the historical state information;

> input the implicit vector corresponding to the historical state information and the current control parameter sequence into a state recurrent prediction layer of the pre-constructed vehicle dynamics model to obtain an implicit vector corresponding to the vehicle state information corresponding to the current time; input the implicit vector corresponding to the vehicle state information corresponding to the current time into a feature decoding layer of the pre-constructed vehicle dynamics model to obtain the vehicle state information corresponding to the current time.

Optionally, the apparatus further includes:

> a fourth obtaining module, configured to obtain current control parameters determined by a preset control parameter determining model based on the vehicle state information of the current time; an eighth determining module, configured to input a target control parameter sequence including the current control parameters and historical state information corresponding to a next time of the current time into the pre-constructed vehicle dynamics model to determine vehicle state information of the target vehicle at the next time of the current time, where the target control parameter sequence further includes: control parameters of various times between the current time and a previous time of a time corresponding to the advanced first time length.

It can be known from the above that, in the method and apparatus for constructing a vehicle dynamics model and a method and an apparatus for predicting vehicle state information according to the embodiments of the present disclosure, sample historical state information and a sample control parameter sequence corresponding to each sample time of a target vehicle and label vehicle state information of each sample time are obtained, where the sample control parameter sequence corresponding to each sample time includes control parameters of the sample time and each time within an advanced first time length; for each sample time, the sample historical state information and the sample control parameter sequence corresponding to the sample time are input into an initial vehicle dynamics model to determine sample prediction state information corresponding to the sample time; for each sample time, by using the sample prediction state information corresponding to the sample time and the label vehicle state information of the sample time, a current loss value corresponding to the initial vehicle dynamics model is determined; based on the current loss value, model parameters of the initial vehicle dynamics model are adjusted until the initial vehicle dynamics model reaches a preset convergence state, so as to obtain a pre-constructed vehicle dynamics model.

In the application of the embodiments of the present disclosure, by using sample historical state information and a sample control parameter sequence corresponding to each sample time of a target vehicle and label vehicle state information of each sample time, an initial vehicle dynamics model is trained to perform supervised learning through the vehicle dynamics model so as to learn a relationship of each sample historical state information and sample control parameter sequence of the target vehicle and the label vehicle state information of the sample time, thereby achieving peer-to-pear modeling for vehicle dynamics without involving any human labor. Further, the data for training the model is collected based on the true situations of the target vehicle, and thus the constructed vehicle dynamics model will be more fit for the characteristics of the vehicle, and further more accurate vehicle state information can be determined by using the pre-constructed vehicle dynamics model. Of course, any product or method for implementing the present disclosure does not need to have all advantages as above at the same time.

The embodiments of the present disclosure have the following creative points.

> 1. Supervised learning is performed through the vehicle dynamics model so as to learn a relationship of each sample historical state information and sample control parameter sequence of the target vehicle and the label vehicle state information of the sample time, thereby achieving peer-to-pear modeling for the vehicle dynamics model without involving any human labor. Further, the data for training the model is collected based on the true situations of the target vehicle, and thus the constructed vehicle dynamics model will be more fit for the characteristics of the vehicle, and further more accurate vehicle state information can be determined by using the pre-constructed vehicle dynamics model.
> 2. The dynamics system is a delay system, that is, the vehicle state information of the sample time is related to the state information of the time corresponding to the advanced second time length of the sample time and also related to the sample control parameter sequence of the time corresponding to the advanced second time length of the sample time and a previous time. Considering the randomness and computing amount of the delay value of the dynamics system, control parameters between the sample time and a time corresponding to the advanced first time length of the sample time are set to a sample control parameter sequence corresponding to the sample time to ensure that the sample control parameter sequence surely includes control parameters relating to the vehicle state information of the sample time and that model training is effective and computing burden is considered. Furthermore, with the above disposal, the model is enabled to implicitly learn the delay value of the dynamics system of the vehicle such that the trained preconstructed vehicle dynamics model can better determine the accurate vehicle state information.

3. The recurrent neural network model, i.e. the preconstructed vehicle dynamics model, which learns the relationship of each sample historical state information and sample control parameter sequence of the target vehicle and the label vehicle state information of the sample time, can determine the vehicle state information of the vehicle at the current time, which is more accurate and more fit for the characteristics of the target vehicle, thus ensuring the travel safety of the vehicle.

## BRIEF DESCRIPTION OF THE DRAWINGS

In order to more clearly describe the technical solutions of the embodiments of the present disclosure or in the prior art, drawings required for description of the embodiments or the prior arts will be briefly introduced below. Apparently, the drawings described hereunder are only some embodiments of the present disclosure. Those skilled in the art may obtain other drawings based on these drawings without making creative work.

FIG. 1 is a flowchart illustrating a method of constructing a vehicle dynamics model according to an embodiment of the present disclosure.
FIG. 2A is a schematic diagram illustrating data flow of a state recurrent prediction layer.
FIG. 2B is a structural schematic diagram illustrating a vehicle dynamics model.
FIG. 3 is a flowchart illustrating a method of predicting vehicle state information according to an embodiment of the present disclosure.
FIG. 4 is a structural schematic diagram illustrating an apparatus for constructing a vehicle dynamics model according to an embodiment of the present disclosure.
FIG. 5 is a structural schematic diagram illustrating an apparatus for predicting vehicle state information according to an embodiment of the present disclosure.

## DETAILED DESCRIPTION OF THE EMBODIMENTS

The technical solutions of the embodiments of the present disclosure will be fully and clearly described below in combination with the accompanying drawings in the embodiments of the present disclosure. Apparently, the embodiments described herein are merely some embodiments of the present disclosure rather than all embodiments. Other embodiments obtained by those skilled in the art based on these embodiments without making creative work shall all fall within the scope of protection of the present disclosure.

It should be noted that the terms "including", "having" and any variation thereof in the embodiments and drawings of the present disclosure are intended to cover non-exclusive inclusion. For example, processes, methods, systems, products or devices including a series of steps or units are not limited to these listed steps or units but may optionally further include steps or units unlisted herein or optionally further include other steps or units inherent to these processes, methods, systems, products or devices.

The present disclosure provides a method and an apparatus for constructing a vehicle dynamics model and a method and an apparatus for predicting vehicle state information, so as to construct a vehicle dynamics model more fit for a vehicle, and further determine accurate vehicle state information. The embodiments of the present disclosure will be detailed below.

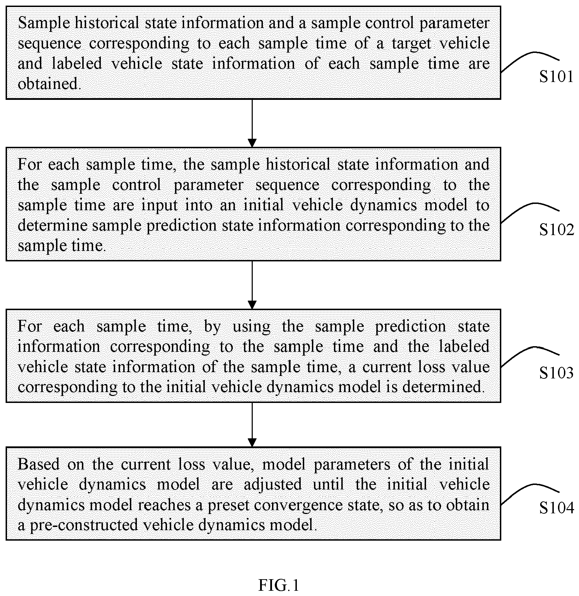

FIG. 1 is a flowchart illustrating a method of constructing a vehicle dynamics model according to an embodiment of the present disclosure. The method includes the following steps.

At step S101, sample historical state information and a sample control parameter sequence corresponding to each sample time of a target vehicle and label vehicle state information of each sample time are obtained.

The sample control parameter sequence corresponding to each sample time includes control parameters of the sample time and each time within an advanced first time length.

The method of constructing a vehicle dynamics model according to the embodiments of the present disclosure may be applied to any first electronic device having computing power, which may be a terminal or a server. In an implementation, a functional software for implementing the method may exist in the form of separate client software, or in the form of a plug-in of the current relevant client software, for example, in the form of a functional module of a dynamics system or the like.

In a case, the first electronic device may be a vehicle-carried device which is disposed inside a target vehicle, or a non-vehicle-carried device capable of obtaining relevant information of the target vehicle, or the like.

If it is required to construct a vehicle dynamics model of a target vehicle, the first electronic device may obtain sample historical state information and a sample control parameter sequence corresponding to each sample time of the target vehicle and label vehicle state information of each sample time, where the label vehicle state information of the sample time is true vehicle state information of the target vehicle at the sample time. The sample historical state information corresponding to the sample time is historical state information corresponding to a time prior to the sample time. The sample control parameter sequence corresponding to the sample time includes control parameters of the sample time and each time within an advanced first time length. The first time length is set base on experiences. Each time corresponds to a plurality of types of control parameters and the types of the control parameters corresponding to each time are same.

In a case, the vehicle state information may include but not limited to: speed, acceleration, yaw rate and pose angle and the like of a vehicle. The types of the control parameters corresponding to each time include but not limited to: brake control amount and throttle control amount and the like.

Considering that the true dynamics system of a vehicle is a delay system, a change amount that the dynamic system changes from a vehicle state O(T-N) of a time T-N to a vehicle state O(T) of a time T is taken as a random variable Y Y is related to a control parameter sequence of (-∞, T-X) and the vehicle state O(T-N) of the time T-N but not related to a control parameter sequence of each time between the time T-N and the time T. Correspondingly, if it is required to predict a change amount from the vehicle state O(T-N) of the time T-N to the vehicle state O(T) of the time T, a control parameter sequence between (T-N-σ, T-σ) is used, where σ represents a delay σ of the dynamics system. In a case, the value of the delay of the dynamics system is about between 1.5 frames and 2.5 frames, i.e. between 30ms and 50ms.

Considering the delay σ of the dynamics system is a random variable, the times corresponding to a head and a tail of a control data sequence for determining the vehicle state of the time T can be expanded to (T-N-σ-A, T), i.e. (T-K, T). When the control data sequence of the times (T-K, T) is used to predict the vehicle state of the time T, input is made to the vehicle dynamics model to enable the vehicle dynamics model to implicitly learn the random variable σ , such that an output result of the pre-constructed vehicle dynamics model subsequently obtained by training achieves a better effect. T, N, σ, A and K are all positive integers and K is greater than N. Correspondingly, N represents the first time length and K represents the second time length.

Correspondingly, in an implementation of the present disclosure, the sample historical state information corresponding to the sample time is vehicle state information of the target vehicle at a time corresponding to the advanced second time length of the sample time, where the second time length is less than the first time length.

At step S102, for each sample time, the sample historical state information and the sample control parameter sequence corresponding to the sample time are input into an initial vehicle dynamics model to determine sample prediction state information corresponding to the sample time.

When training the initial vehicle dynamics model by using the sample historical state information and the sample control parameter sequence corresponding to each sample time and the label vehicle state information of each sample time, the first electronic device may train the initial vehicle dynamics model by using single-frame data, that is, for each sample time, the initial vehicle dynamics model is trained by using the sample historical state information and the sample control parameter sequence corresponding to the sample time and the label vehicle state information of the sample time. Correspondingly, for each sample time, the first electronic device inputs the sample historical state information and the sample control parameter sequence corresponding to the sample time into the initial vehicle dynamics model to determine sample prediction state information corresponding to the sample time.

In an implementation, the initial vehicle dynamics model is a recurrent neural network model based on deep learning, which may include a feature coding layer, a state recurrent prediction layer and a feature decoding layer. In a case, the feature coding layer and the feature decoding layer may be implemented by a fully-connected layer, and the state recurrent prediction layer may be implemented by a Gated Recurrent Unit (GRU).

At step S103, for each sample time, by using the sample prediction state information corresponding to the sample time and the label vehicle state information of the sample time, a current loss value corresponding to the initial vehicle dynamics model is determined.

In an implementation, for each sample time, the first electronic device may, by using the sample prediction state information corresponding to the sample time and the label vehicle state information of the sample time, calculate a distance between the sample prediction state information corresponding to the sample time and the label vehicle state information, and determine the calculated distance as a current loss value corresponding to the initial vehicle dynamics model.

In another implementation, for each sample time, the first electronic device may, by using the sample prediction state information corresponding to the sample time and the label vehicle state information of the sample time, calculate a distance between the sample prediction state information corresponding to the sample time and the label vehicle state information; determine an average value or a sum of the distances between the sample prediction state information corresponding to a preset number of sample times and the label vehicle state information as a current loss value corresponding to the initial vehicle dynamics model.

At step S 104, based on the current loss value, model parameters of the initial vehicle dynamics model are adjusted until the initial vehicle dynamics model reaches a preset convergence state, so as to obtain a pre-constructed vehicle dynamics model.

In this step, the first electronic device may firstly determine whether the current loss value is greater than a preset loss threshold; if the current loss value is greater than the preset loss threshold, the first electronic device may determine the initial vehicle dynamics model does not converge, and use a preset optimization algorithm to adjust the model parameters of the initial vehicle dynamics model and return to, for each sample time, input the sample historical state information and the sample control parameter sequence corresponding to the sample time into the parameter-adjusted initial dynamics model to determine the sample prediction state information corresponding to the sample time, and further, based on the sample prediction state information corresponding to the sample time and the label vehicle state information of the sample time, determine a loss value corresponding to the initial vehicle dynamics model as the current loss value, and then re-determine whether the current loss value is greater than the preset loss threshold; if the current loss value is greater than the preset loss threshold, the first electronic device may continue using the preset optimization algorithm to adjust the model parameters of the parameter-adjusted initial vehicle dynamics model and so on, until it is determined that the loss value corresponding to the parameter-adjusted initial vehicle dynamics model is not greater than the preset loss threshold. Thus, it is determined that the parameter-adjusted initial vehicle dynamics model reaches the preset convergence state, and hence, the current parameter-adjusted initial vehicle dynamics model is determined as the pre-constructed vehicle dynamics model.

The preset optimization algorithm may be gradient descent method, least square method or genetic algorithm or the like. The current loss value may be calculated based on LOSS function, for example, based on L2LOSS function.

In the application of the embodiments of the present disclosure, by using sample historical state information and a sample control parameter sequence corresponding to each sample time of a target vehicle and label vehicle state information of each sample time, an initial vehicle dynamics model is trained to perform supervised learning through the vehicle dynamics model so as to learn a relationship of each sample historical state information and sample control parameter sequence of the target vehicle and the label vehicle state information of the sample time, thereby achieving peer-to-pear modeling for vehicle dynamics without involving any human labor. Further, the data for training the model is collected based on the true situations of the target vehicle, and thus the constructed vehicle dynamics model will be more fit for the characteristics of the vehicle, and further more accurate vehicle state information can be determined by using the pre-constructed vehicle dynamics model.

In another embodiment of the present disclosure, the step S102 may include the following steps 011 to 013.

At step 011, for each sample time, the sample historical state information corresponding to the sample time is input into a feature coding layer of the initial vehicle dynamics model to obtain an implicit vector corresponding to the sample historical state information corresponding to the sample time.

At step 012, for each sample time, the implicit vector corresponding to the sample historical state information corresponding to the sample time and the sample control parameter sequence corresponding to the sample time are input into a state recurrent prediction layer of the initial vehicle dynamics model to obtain an implicit vector corresponding to the vehicle state information corresponding to the sample time.

At step 013, for each sample time, the implicit vector corresponding to the vehicle state information corresponding to the sample time is input into a feature decoding layer of the initial vehicle dynamics model to determine the sample prediction state information corresponding to the sample time.

In this implementation, the historical state information corresponding to the sample time is state information of a time corresponding to the advanced second time length of the sample time, which is single-frame data. In order to ensure subsequent effective training for the initial vehicle dynamics model, the first electronic device, for each sample time, inputs the sample historical state information corresponding to the sample time into the feature coding layer of the initial vehicle dynamics model to obtain an implicit vector corresponding to the sample historical state information corresponding to the sample time, and inputs the implicit vector corresponding to the sample historical state information corresponding to the sample time as an initial state vector and the sample control parameter sequence corresponding to the sample time into the state recurrent prediction layer of the initial vehicle dynamics model, such that the state recurrent prediction layer, based on the initial state vector and the sample control parameter sequence corresponding to the sample time, sequentially recurrently determines an implicit vector corresponding to the vehicle state information of each time after a time corresponding to the initial state vector until an implicit vector corresponding to the vehicle state information of the sample time is determined.

Further, the first electronic device, for each sample time, inputs the implicit vector corresponding to the vehicle state information corresponding to the sample time into the feature decoding layer of the initial vehicle dynamics model for decoding to obtain the sample prediction state information corresponding to the sample time, that is, the predicted vehicle state information corresponding to the sample time.

In an implementation, the feature coding layer of the initial vehicle dynamics model may be implemented by using one 32-dimensional fully-connected layer. The state recurrent prediction layer of the initial vehicle dynamics model may be implemented by using a gated recurrent unit (GRU). The feature decoding layer of the initial vehicle dynamics model may be implemented by using one 16-dimensional fully-connected layer and one 3-dimensional fully-connected layer.

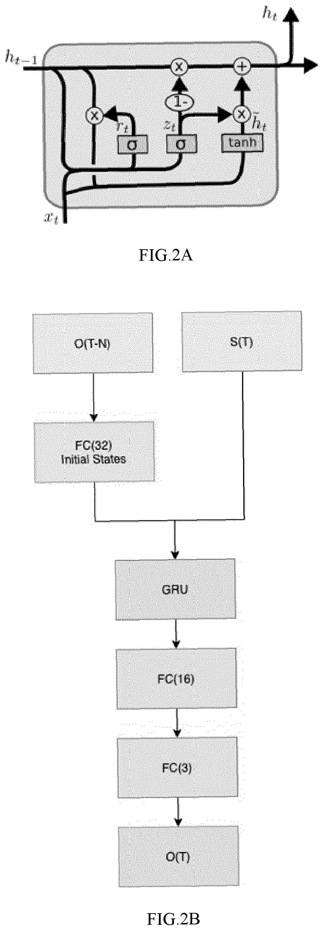

As shown in FIG. 2A, it is a schematic diagram of data flow of a state recurrent prediction layer, where $z_t$ and $r_t$ respectively represent a value corresponding to an update gate and a value corresponding to a reset gate. The update gate is used to control a degree that the vehicle state information of the time $t - 1$ is brought to the vehicle state information of the time $t$. A larger value of the update gate indicates that more vehicle state information of the time $t - 1$ is brought in. The reset gate is used to control an amount that the vehicle state information of the time $t - 1$ is written into the vehicle state information of the time $t$. A smaller value of the reset gate indicates that less vehicle state information of the time $t - 1$ is written.

In the state recurrent prediction layer, processing procedures are represented by the following formulas:

$$z_t = \sigma \ (W_z \cdot [h_{t-1}, x_t]) \ ;$$

$$r_t = \sigma \ (W_r \cdot [h_{t-1}, x_t]) \ ;$$

$$\tilde{h}_t = tanh \ (W \cdot [r_t * h_{t-1}, x_t]) \ ;$$

$$h_t = (1 - z_t) * h_{t-1} + z_t * \tilde{h}_t;$$

where $W_z$, $W_r$ and W are parameters of the state recurrent prediction layer, which are obtained by training; $h_{t-1}$ represents the vehicle state information of the time $t - 1$; during a training process, the initial value of the $h_{t-1}$ is the sample historical state inforamtion corresponding to the sample time; in a subsequent practical prediction process, the initial value of the $h_{t-1}$ is the historical state information corresponding to the current time; $h_t$ represents the vehicle state information of the time $t$; in a training process, $h_t$ is the sample prediction state information corresponding to the sample time; in a subsequent practical prediction process, $h_t$ is the vehicle state information corresponding to the current time; in a training process, $x_t$ is the sample control parameter sequence corresponding to the sample time; in a subsequent practical prediction process, $x_t$ is the current control parameter sequence corresponding to the current time. In the above formulas, [] represents connection of two vectors and * represents a product of a matrix.

In another embodiment of the present disclosure, the method further includes: a test process for a pre-constructed vehicle dynamics model to determine whether a vehicle state determined by the pre-constructed vehicle dynamics model is good or not. Correspondingly, after step S104, the method may further include the following steps 021 to 024.

At step 021, raw test data of the target vehicle is obtained.

The raw test data includes: test historical state information, a test control parameter sequence and test vehicle state information corresponding to each test time generated during a travel process of the target vehicle; the test control parameter sequence corresponding to each test time includes: control parameters of the test time and each time within the advanced first time length, and the test historical state information corresponding to the test time is: vehicle state information of a time corresponding to the advanced second time length of the test time.

At step 022, test historical state information and a test control parameter sequence corresponding to a first test time are input into the pre-constructed vehicle dynamics model to determine test prediction state information corresponding to the first test time.

The first test time includes: an earliest test time and each time prior to the time corresponding to the second time length after the earliest test time.

At step 023, prediction historical state information and a test control parameter sequence corresponding to a second test time are input into the pre-constructed vehicle dynamics model to determine test prediction state information corresponding to the second test time.

The second test time is a time other than the first test time in the test times, and the prediction historical state information corresponding to the second test time is test prediction state information corresponding to a time corresponding to the advanced second time length of the second test time.

At step 024, by using the test prediction state information and the test vehicle state information corresponding to each test time, a test result of the pre-constructed vehicle dynamics model is determined.

In this implementation, in order to test the accuracy of the prediction result of the pre-constructed vehicle dynamics model, the first electronic device may firstly obtain the raw test data of the target vehicle, where the raw test data includes: test historical state information, a test control parameter sequence and test vehicle state information corresponding to each test time generated during a travel process of the target vehicle. For the purpose of clarity of descriptions, the times corresponding to the data used in the test process are referred to as test times, where the test vehicle state information corresponding to each test time is true vehicle state information of the target vehicle.

The first electronic device, based on a time sequence of the first test times, sequentially inputs the test historical state information and the test control parameter sequences corresponding to the first test times into the pre-constructed vehicle dynamics model, such that the test prediction state information corresponding to each first test time is determined by using the feature coding layer, the state recurrent prediction layer and the feature decoding layer of the pre-constructed vehicle dynamics model.

As shown in FIG. 2B, when a vehicle state corresponding to the time T is predicted, it is required to use a vehicle state corresponding to the time T-N, i.e., "O(T-N)" indicated in FIG. 2B, and the control parameter sequence from the time T-K to the time T, i.e. "S(T)" indicated in FIG. 2B, where N represents the first time length and K represents the second time length, and N is less than K. When the time T is the earliest test time in the test times, the times of T to T+N-1 are the first test times. Correspondingly, when its corresponding vehicle state information, i.e. corresponding test prediction state information, is determined, it is required to use the test historical state information and the test control parameter sequence corresponding to the first test time in the raw test data.

As shown in FIG. 2B, when a vehicle state corresponding to the time T is predicted, coding is performed by using O(T-N) and S(T) as the feature coding layer of the pre-constructed vehicle dynamics model, i.e. a 32-dimensional fully-connected layer "FC(32)Initial States" to obtain a corresponding implicit vector; the implicit vector as an initial state vector and the S(T) are input into the state recurrent prediction layer, i.e. the GRU as shown in FIG. 2B, such that, based on the initial state vector and the S(T), i.e. the control parameter sequence of from the time T-K to the time T, an implicit vector corresponding to the vehicle state information of each time after a time corresponding to the initial state vector is sequentially recurrently determined, until an implicit vector corresponding to the vehicle state corresponding to the time T is determined. The implicit vector corresponding to the vehicle state corresponding to the time T is input into the feature decoding layer, i.e. one 16-dimensional fully-connected layer, for example, "FC(16)" as shown in FIG. 2B and one 3-dimensional fully-connected layer, for example, "FC(3)" as shown in FIG. 2B, so as to perform decoding on the implicit vector corresponding to vehicle state corresponding to the time T and obtain a vehicle state corresponding to the time T, for example, O(T) shown in FIG. 2.

Correspondingly, when the vehicle state information corresponding to the time T+N, i.e. the corresponding test prediction state information is calculated by starting from the time T+N, it is required to use the vehicle state corresponding to the time T and the control parameter sequence of from the time T+N-K to the time T+N. At this time, the vehicle state corresponding to the time T includes: test vehicle state information corresponding to the time T in the raw test data as well as the test prediction state information output by the pre-constructed vehicle dynamics model.

In order to test the accuracy of the prediction determination result of the pre-constructed vehicle dynamics model, when the test prediction state information corresponding to the time T+N is determined, it is required to take the test prediction state information corresponding to the time T as the test historical state information corresponding to the time T+N and correspondingly input the test prediction state information corresponding to the time T and the test control parameter sequence corresponding to the time T+N, i.e. the control parameter sequence of from the time T+N-K to the time T+N in the raw test data, into the pre-constructed vehicle dynamics model to determine the test prediction state information corresponding to the second test time. By analogy, the test prediction state information of each time after the time T+N can be calculated in sequence. Correspondingly, the time T+N and each time after the time T+N are the above second test times.

Correspondingly, after the test prediction state information corresponding to each first test time is determined, the first electronic device may, based on a time sequence of the second test times, sequentially input the prediction historical state information and the test control parameter sequences corresponding to the second test times into the pre-constructed vehicle dynamics model such that the test prediction state information corresponding to each second test time is determined by using the feature coding layer, the state recurrent prediction layer and the feature decoding layer of the pre-constructed vehicle dynamics model. The prediction historical state information corresponding to the second test time is test prediction state information corresponding to a time corresponding to the advanced second time length of the second test time. For example, when the second test time is the time T+N, the prediction historical state information corresponding to the second test time is test prediction state information corresponding to the time T and output by the pre-constructed vehicle dynamics model.

After the test prediction state information corresponding to each test time is determined, a distance between the test prediction state information and the test vehicle state information corresponding to each test time is calculated based on the test prediction state information and the test vehicle state information corresponding to each test time; based on the distance between the test prediction state information and the test vehicle state information corresponding to each test time, a test result of the pre-constructed vehicle dynamics model is determined.

The process of determining the test result of the pre-constructed vehicle dynamics model may include: determining a number of distances not exceeding a preset distance threshold in the distances between the test prediction state information and the test vehicle state information corresponding to the test times; if a ratio of the number of the distances not exceeding the preset distance threshold to a total number of distances exceeds a preset ratio, determining the test result of the pre-constructed vehicle dynamics model includes information representing the pre-constructed vehicle dynamics model passes test; otherwise, if the ratio of the number of the distances not exceeding the preset distance threshold to the total number of distances does not exceed the preset ratio, determining the test result of the pre-constructed vehicle dynamics model includes information representing the pre-constructed vehicle dynamics model fails to pass test. In the embodiments of the present disclosure, the process of determining the test result of the pre-constructed vehicle dynamics model is not specifically limited.

When it is determined that the pre-constructed vehicle dynamics model passes test, the pre-constructed vehicle dynamics model can be applied to a process of determining the vehicle state information of the target vehicle. Otherwise, when it is determined that the pre-constructed vehicle dynamics model fails to pass test, it is required to perform training again to obtain a pre-constructed vehicle dynamics model.

In an embodiment of the present disclosure, the data used for training and testing the vehicle dynamics model includes control parameters and vehicle state information recorded during a travel process of the target vehicle. The data used for training and testing the vehicle dynamics model does not need to be labeled manually, saving human labor costs to some extent. The vehicle dynamics model does not need to maintain any internal state. When the model predicts a vehicle state at single time, the input vehicle state information is the vehicle state information of one historical frame or time. Each frame corresponds to one independent sample, which increases the number of pieces of sample data for training and testing the vehicle dynamics model to some extent and reduces the computing difficulty of the training process and subsequent test and actual prediction determining processes. The model can start prediction at any time without any warm-up, that is, can start performing the prediction determining process of the vehicle state information once the target vehicle is in a stationary state.

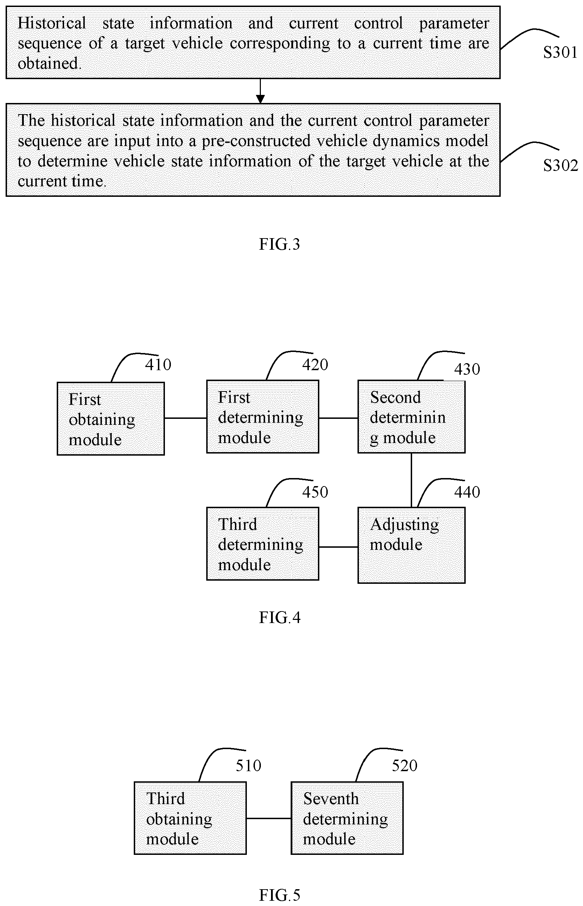

Corresponding to the above method embodiment, an embodiment of the present disclosure provides a method of predicting vehicle state information, which relies on the pre-constructed vehicle dynamics model constructed in the above method embodiments. As shown in FIG. 3, the method includes the following steps S301 to S302.

At step S301, historical state information and current control parameter sequence of a target vehicle corresponding to a current time are obtained.

The current control parameter sequence includes: control parameters of the current time and each time within an advanced first time length.

The method of predicting vehicle state information according to an embodiment of the present disclosure may be applied to a second electronic device having computing power, which may be a terminal or a server. In an implementation, a functional software for implementing the method may exist in the form of separate client software, or in the form of a plug-in of the current relevant client software, for example, in the form of a functional module of a dynamics system or the like. The second electronic device and the above first electronic device may be a same physical device or different physical devices.

In a case, the second electronic device may be a vehicle-carried device which is disposed inside a target vehicle, or a non-vehicle-carried device capable of obtaining relevant information of the target vehicle, or the like.

When predicting and determining vehicle state information of a target vehicle, the second electronic device may obtain historical state information and current control parameter sequence of the target vehicle corresponding to a current time, where the historical state information corresponding to the current time is historical state information corresponding to a time prior to the current time. The current control parameter sequence corresponding to the current time includes: control parameters of the current time and each time within an advanced first time length. The first time length is set based on experiences. Each time corresponds to a plurality of types of control parameters and the types of the control parameters corresponding to each time are same.

In a case, the vehicle state information may include but not limited to: speed, acceleration, yaw rate and pose angle and the like of a vehicle. The types of the control parameters corresponding to each time include but not limited to: brake control amount and throttle control amount and the like.

Considering the true dynamics system of the vehicle is a delay system, in an implementation of the present disclosure, the historical state information is vehicle state information corresponding to a time corresponding to an advanced send time length of the current time, where the second time length is less than the first time length.

At step S302, the historical state information and the current control parameter sequence are input into a pre-constructed vehicle dynamics model to determine vehicle state information of the target vehicle at the current time.

The pre-constructed vehicle dynamics model is a recurrent neural network model obtained by training based on sample state information and sample control parameter sequence corresponding to each historical time of the target vehicle and may include a feature coding layer, a state recurrent prediction layer and a feature decoding layer. In a case, the feature coding layer and the feature decoding layer may be implemented by a fully-connected layer, and the state recurrent prediction layer may be implemented by a Gated Recurrent Unit (GRU).

The second electronic device inputs the historical state information and the current control parameter sequence into the pre-constructed vehicle dynamics model. The pre-constructed vehicle dynamics model processes the historical state information and the current control parameter sequence by using its feature coding layer, state recurrent prediction layer and feature decoding layer to determine the vehicle state information of the target vehicle at the current time. Further, the vehicle state information of the target vehicle at the current time is output such that a travel state of the target vehicle can be controlled based on the vehicle state information of the target vehicle at the current time.

In application of the embodiments of the present disclosure, the recurrent neural network model, i.e. the pre-constructed vehicle dynamics model which learns the relationship of each sample historical state information and sample control parameter sequence of the target vehicle and the label vehicle state information of the sample time, can determine the vehicle state information of the vehicle at the current time, which is more accurate and more fit for the characteristics of the target vehicle, thus ensuring the travel safety of the vehicle.

In another embodiment of the present disclosure, the step S302 further includes the following steps 031 to 033.

At step 031, the historical state information is input into the feature coding layer of the pre-constructed vehicle dynamics model to obtain an implicit vector corresponding to the historical state information.

At step 032, the implicit vector corresponding to the historical state information and the current control parameter sequence are input into the state recurrent prediction layer of the pre-constructed vehicle dynamics model to obtain an implicit vector corresponding to the vehicle state information corresponding to the current time.

At step 033, the implicit vector corresponding to the vehicle state information corresponding to the current time is input into the feature decoding layer of the pre-constructed vehicle dynamics model to obtain the vehicle state information corresponding to the current time.

In this implementation, the historical state information corresponding to the current time is state information of a time corresponding to the advanced second time length of the current time, which is single-frame data. In order to ensure subsequent effective prediction and determination by the pre-constructed vehicle dynamics model, the second electronic device inputs the historical state information corresponding to the current time into the feature coding layer of the pre-constructed vehicle dynamics model to obtain an implicit vector corresponding to the historical state information corresponding to the current time, and inputs the implicit vector corresponding to the historical state information corresponding to the current time as an initial state vector and the current control parameter sequence into the state recurrent prediction layer of the pre-constructed vehicle dynamics model, such that the state recurrent prediction layer, based on the initial state vector and the current control parameter sequence, sequentially recurrently determines an implicit vector corresponding to the vehicle state information of each time after a time corresponding to the initial state vector until an implicit vector corresponding to the vehicle state information of the current time is determined.

Furthermore, the second electronic device inputs the implicit vector corresponding to the vehicle state information corresponding to the current time into the feature decoding layer of the pre-constructed vehicle dynamics model for decoding to obtain the vehicle state information corresponding to the current time.

In an implementation, the feature coding layer of the pre-constructed vehicle dynamics model may be implemented by using one 32-dimensional fully-connected layer. The state recurrent prediction layer of the pre-constructed vehicle dynamics model may be implemented by using a gated recurrent unit (GRU). The feature decoding layer of the pre-constructed vehicle dynamics model may be implemented by using one 16-dimensional fully-connected layer and one 3-dimensional fully-connected layer.

In another embodiment of the present disclosure, the method may further include the following steps 041 to 042.

At step 041, current control parameters determined by a preset control parameter determining model based on the vehicle state information of the current time are obtained.

At step 042, a target control parameter sequence including the current control parameters and historical state information corresponding to a next time of the current time are input into the pre-constructed vehicle dynamics model to determine the vehicle state information of the target vehicle at the next time of the current time.

The target control parameter sequence further includes: control parameters of various times between the current time and a previous time of a time corresponding to the advanced first time length.

In this implementation, the second electronic device may, after determining the vehicle state information of the current time, input the vehicle state information of the current time into the preset control parameter determining model, such that the preset control parameter determining model, based on the vehicle state information of the current time, determines control parameters of the target vehicle corresponding to a next time of the current time. Correspondingly, the second electronic device obtains control parameters corresponding to the next time of the current time; adds the control parameters corresponding to the next time of the current time to the target control parameter sequence and takes the sequence as the control parameter sequence corresponding to the next time of the current time; inputs the target control parameter sequence including the current control parameters and the historical state information corresponding to the next time of the current time into the pre-constructed vehicle dynamics model to determine the vehicle state information of the target vehicle at the next time of the current time.

The preset control parameter determining model may use any determination algorithm for determining vehicle control parameters in the prior arts to, based on the vehicle state information of the current time, determine control parameters corresponding to the next time of the current time for controlling the travel of the target vehicle.

Corresponding to the above method embodiments, an embodiment of the present disclosure provides an apparatus for constructing a vehicle dynamics model. As shown in FIG. 4, the apparatus includes:

> a first obtaining module 410, configured to obtain sample historical state information and a sample control parameter sequence corresponding to each sample time of a target vehicle and label vehicle state information of each sample time, wherein the sample control parameter sequence corresponding to each sample time includes control parameters of the sample time and each time within an advanced first time length;
> a first determining module 420, configured to, for each sample time, input the sample historical state information and the sample control parameter sequence corresponding to the sample time into an initial vehicle dynamics model to determine sample prediction state information corresponding to the sample time;
> a second determining module 430, configured to, for each sample time, by using the sample prediction state information corresponding to the sample time and the label vehicle state information of the sample time, determine a current loss value corresponding to the initial vehicle dynamics model;
> an adjusting module 440, configured to, based on the current loss value, adjust model parameters of the initial vehicle dynamics model until the initial vehicle dynamics model reaches a preset convergence state, so as to obtain a pre-constructed vehicle dynamics model.

In the application of the embodiments of the present disclosure, by using sample historical state information and a sample control parameter sequence corresponding to each sample time of a target vehicle and label vehicle state information of each sample time, an initial vehicle dynamics model is trained to perform supervised learning through the vehicle dynamics model so as to learn a relationship of each sample historical state information and sample control parameter sequence of the target vehicle and the label vehicle state information of the sample time, thereby achieving peer-to-pear modeling for vehicle dynamics without involving any human labor. Further, the data for training the model is collected based on the true situations of the target vehicle, and thus the constructed vehicle dynamics model will be more fit for the characteristics of the vehicle, and further more accurate vehicle state information can be determined by using the pre-constructed vehicle dynamics model.

In another embodiment of the present disclosure, the sample historical state information corresponding to the sample time is state information of the target vehicle at a time corresponding to an advanced second time length of the sample time, where the second time length is less than the first time length.

In another embodiment of the present disclosure, the first determining module 420 is specifically configured to: for each sample time, input the sample historical state information corresponding to the sample time into a feature coding layer of the initial vehicle dynamics model to obtain an implicit vector corresponding to the sample historical state information corresponding to the sample time;

> for each sample time, input the implicit vector corresponding to the sample historical state information corresponding to the sample time and the sample control parameter sequence corresponding to the sample time into a state recurrent prediction layer of the initial vehicle dynamics model to obtain an implicit vector corresponding to the vehicle state information corresponding to the sample time;
> for each sample time, input the implicit vector corresponding to the vehicle state information corresponding to the sample time into a feature decoding layer of the initial vehicle dynamics model to determine the sample prediction state information corresponding to the sample time.

In another embodiment of the present disclosure, the apparatus further includes:

> a second obtaining module (not shown), configured to: after obtaining the pre-constructed vehicle dynamics model when determining the initial vehicle dynamics model converges, obtain raw test data of the target vehicle, where the raw test data includes: test historical state information, a test control parameter sequence and test vehicle state information corresponding to each test time generated during a travel process of the target vehicle, the test control parameter sequence corresponding to each test time includes: control parameters of the test time and each time within the advanced first time length, and the test historical state information corresponding to the test time is: vehicle state information of a time corresponding to the advanced second time length of the test time;
> a fourth determining module (not shown), configured to input test historical state information and a test control parameter sequence corresponding to a first test time into the pre-constructed vehicle dynamics model to determine test prediction state information corresponding to the first test time, where the first test time includes an earliest test time and each time prior to the time corresponding to the second time length after the earliest test time;
> a fifth determining module (not shown), configured to input prediction historical state information and a test control parameter sequence corresponding to a second test time into the pre-constructed vehicle dynamics model to determine test prediction state information corresponding to the second test time, where the second test time is a time other than the first test time in the test times, and the prediction historical state information corresponding to the second test time is test prediction state information corresponding to a time corresponding to the advanced second time length of the second test time;
a sixth determining module (not shown), configured to, by using the test prediction state information and the test vehicle state information corresponding to each test time, determine a test result of the pre-constructed vehicle dynamics model.

Corresponding to the above method embodiments, an embodiment of the present disclosure provides an apparatus for predicting vehicle state information. As shown in FIG. 5, the apparatus includes:

a third obtaining module 510, configured to obtain historical state information and current control parameter sequence corresponding to a target vehicle at a current time, where the current control parameter sequence includes: control parameters of the current time and each time within an advanced first time length;
a seventh determining module 520, configured to input the historical state information and the current control parameter sequence into a pre-constructed vehicle dynamics model to determine vehicle state information of the target vehicle at the current time, where the pre-constructed vehicle dynamics model is a recurrent neural network model obtained by training based on sample state information and sample control parameter sequence corresponding to each historical time of the target vehicle.

In application of the embodiments of the present disclosure, the recurrent neural network model, i.e. the pre-constructed vehicle dynamics model which learns the relationship of each sample historical state information and sample control parameter sequence of the target vehicle and the label vehicle state information of the sample time, can determine the vehicle state information of the target vehicle at the current time, which is more accurate and more fit for the characteristics of the target vehicle, thus ensuring the travel safety of the vehicle.

In another embodiment of the present disclosure, the historical state information is vehicle state information of the target vehicle at a time corresponding to an advanced second time length of the current time, and the second time length is less than the first time length.

In another embodiment of the present disclosure, the seventh determining module 520 is specifically configured to input the historical state information into a feature coding layer of the pre-constructed vehicle dynamics model to obtain an implicit vector corresponding to the historical state information;

input the implicit vector corresponding to the historical state information and the current control parameter sequence into a state recurrent prediction layer of the pre-constructed vehicle dynamics model to obtain an implicit vector corresponding to the vehicle state information corresponding to the current time;
input the implicit vector corresponding to the vehicle state information corresponding to the current time into a feature decoding layer of the pre-constructed vehicle dynamics model to obtain the vehicle state information corresponding to the current time.

In another embodiment of the present disclosure, the apparatus further includes:

a fourth obtaining module (not shown), configured to obtain current control parameters determined by a preset control parameter determining model based on the vehicle state information of the current time;
an eighth determining module (not shown), configured to input a target control parameter sequence including the current control parameters and historical state information corresponding to a next time of the current time into the pre-constructed vehicle dynamics model to determine vehicle state information of the target vehicle at the next time of the current time, where the target control parameter sequence further includes: control parameters of various times between the current time and a previous time of a time corresponding to the advanced first time length.

Corresponding to the method embodiments, the system and apparatus embodiments have the same technical effects with detailed descriptions referred to the method embodiments. The apparatus embodiments are obtained based on method embodiments and detailed descriptions may be referred to the corresponding part of the method embodiments and will not be repeated herein. Persons of ordinary skills in the prior art may understand that the drawings are only illustrations of the embodiments and the modules or flows in the drawings are not necessary for implementing the present disclosure.

Persons of ordinary skills in the prior art may understand that the modules in the apparatus of the embodiments may be distributed in the apparatus of the embodiments based on the descriptions of the embodiments, or changed accordingly to be located in one or more apparatuses different from the present embodiments. The modules in the above embodiments may be combined into one module or split into a plurality of submodules.

Finally, it should be noted that, the above embodiments are used only to describe the technical solutions of the present disclosure rather than limit the present disclosure. Although detailed descriptions are made to the present disclosure by referring to the preceding embodiments, those skilled in the art should understand that the technical solutions recorded in the preceding embodiments can be modified or part of the technical features therein is equivalently replaced. These modifications or substitutions will not cause the corresponding technical solutions to depart from the spirit and scope of the technical solutions of the embodiments of the present disclosure.

**Claims**

1. A method of constructing a vehicle dynamics model, comprising:

   obtaining sample historical state information and a sample control parameter sequence corresponding to each sample time of a target vehicle and label vehicle state information of each sample time, wherein the sample control parameter sequence corresponding to each sample time comprises control parameters of the sample time and each time within an advanced first time length;
   for each sample time, inputting the sample historical state information and the sample control parameter sequence corresponding to the sample time into an initial vehicle dynamics model to determine sample prediction state information corresponding to the sample time;
   for each sample time, by using the sample prediction state information corresponding to the sample time and the label vehicle state information of the sample time, determining a current loss value corresponding to the initial vehicle dynamics model;
   based on the current loss value, adjusting model parameters of the initial vehicle dynamics model until the initial vehicle dynamics model reaches a preset convergence state so as to obtain a pre-constructed vehicle dynamics model.

2. The method of claim 1, wherein the sample historical state information corresponding to the sample time is vehicle state information of the target vehicle at a time corresponding to an advanced second time length of the sample time, wherein the second time length is less than the first time length.

3. The method of claim 1, wherein for each sample time, inputting the sample historical state information and the sample control parameter sequence corresponding to the sample time into the initial vehicle dynamics model to determine the sample prediction state information corresponding to the sample time comprises:

for each sample time, inputting the sample historical state information corresponding to the sample time into a feature coding layer of the initial vehicle dynamics model to obtain an implicit vector corresponding to the sample historical state information corresponding to the sample time;
for each sample time, inputting the implicit vector corresponding to the sample historical state information corresponding to the sample time and the sample control parameter sequence corresponding to the sample time into a state recurrent prediction layer of the initial vehicle dynamics model to obtain an implicit vector corresponding to the vehicle state information corresponding to the sample time;
for each sample time, inputting the implicit vector corresponding to the vehicle state information corresponding to the sample time into a feature decoding layer of the initial vehicle dynamics model to determine the sample prediction state information corresponding to the sample time.

4. The method of claim 1, wherein after the step of obtaining the pre-constructed vehicle dynamics model when determining the initial vehicle dynamics model converges, the method further comprises:

   obtaining raw test data of the target vehicle, wherein the raw test data comprises: test historical state information, a test control parameter sequence and test vehicle state information corresponding to each test time generated during a travel process of the target vehicle, the test control parameter sequence corresponding to each test time comprises: control parameters of the test time and each time within the advanced first time length, and the test historical state information corresponding to the test time is: vehicle state information of a time corresponding to the advanced second time length of the test time;
   inputting test historical state information and a test control parameter sequence corresponding to a first test time into the pre-constructed vehicle dynamics model to determine test prediction state information corresponding to the first test time, wherein the first test time comprises an earliest test time and each time prior to the time corresponding to the second time length after the earliest test time;
   inputting prediction historical state information and a test control parameter sequence corresponding to a second test time into the pre-constructed vehicle dynamics model to determine test prediction state information corresponding to the second test time, wherein the second test time is a time other than the first test time in the test times, and the prediction historical state information corresponding to the second test time is test prediction state information corresponding to a time corresponding to the advanced second time length of the second test time;

by using the test prediction state information and the test vehicle state information corresponding to each test time, determining a test result of the pre-constructed vehicle dynamics model.

5. A method of predicting vehicle state information based on the vehicle dynamics model constructed according to the method of any one of claims 1 to 4, comprising:

obtaining historical state information and current control parameter sequence of a target vehicle corresponding to a current time, wherein the current control parameter sequence comprises: control parameters of the current time and each time within an advanced first time length;

inputting the historical state information and the current control parameter sequence into a pre-constructed vehicle dynamics model to determine vehicle state information of the target vehicle at the current time, wherein the pre-constructed vehicle dynamics model is a recurrent neural network model obtained by training based on sample state information and sample control parameter sequence corresponding to each historical time of the target vehicle.

6. The method of claim 5, wherein the historical state information is vehicle state information of the target vehicle at a time corresponding to an advanced second time length of the current time, and the second time length is less than the first time length.

7. The method of claim 5 or 6, wherein inputting the historical state information and the current control parameter sequence into the pre-constructed vehicle dynamics model to determine the vehicle state information of the target vehicle at the current time comprises:

inputting the historical state information into a feature coding layer of the pre-constructed vehicle dynamics model to obtain an implicit vector corresponding to the historical state information;

inputting the implicit vector corresponding to the historical state information and the current control parameter sequence into a state recurrent prediction layer of the pre-constructed vehicle dynamics model to obtain an implicit vector corresponding to the vehicle state information corresponding to the current time;

inputting the implicit vector corresponding to the vehicle state information corresponding to the current time into a feature decoding layer of the pre-constructed vehicle dynamics model to obtain the vehicle state information corresponding to the current time.

8. The method of claim 5 or 6, further comprising:

obtaining current control parameters determined by a preset control parameter determining model based on the vehicle state information of the current time;

inputting a target control parameter sequence comprising the current control parameters and historical state information corresponding to a next time of the current time into the pre-constructed vehicle dynamics model to determine vehicle state information of the target vehicle at the next time of the current time, wherein the target control parameter sequence further comprises: control parameters of various times between the current time and a previous time of a time corresponding to the advanced first time length.

9. An apparatus for constructing a vehicle dynamics model, comprising:

a first obtaining module, configured to obtain sample historical state information and a sample control parameter sequence corresponding to each sample time of a target vehicle and label vehicle state information of each sample time, wherein the sample control parameter sequence corresponding to each sample time comprises control parameters of the sample time and each time within an advanced first time length;

a first determining module, configured to, for each sample time, input the sample historical state information and the sample control parameter sequence corresponding to the sample time into an initial vehicle dynamics model to determine sample prediction state information corresponding to the sample time;

a second determining module, configured to, for each sample time, by using the sample prediction state information corresponding to the sample time and the label vehicle state information of the sample time, determine a current loss value corresponding to the initial vehicle dynamics model;

an adjusting module, configured to, based on the current loss value, adjust model parameters of the initial vehicle dynamics model until the initial vehicle dynamics model reaches a preset convergence state, so as to obtain a pre-constructed vehicle dynamics model.

**10.** An apparatus for predicting vehicle state information based on the vehicle dynamics model constructed by using the apparatus of claim 9, comprising:

a third obtaining module, configured to obtain historical state information and current control parameter sequence of a target vehicle corresponding a current time, wherein the current control parameter sequence comprises: control parameters of the current time and each time within an advanced first time length;

a seventh determining module, configured to input the historical state information and the current control parameter sequence into a pre-constructed vehicle dynamics model to determine vehicle state information of the target vehicle at the current time, wherein the pre-constructed vehicle dynamics model is a recurrent neural network model obtained by training based on sample state information and sample control parameter sequence corresponding to each historical time of the target vehicle.

Sample historical state information and a sample control parameter sequence corresponding to each sample time of a target vehicle and labeled vehicle state information of each sample time are obtained.

S101

For each sample time, the sample historical state information and the sample control parameter sequence corresponding to the sample time are input into an initial vehicle dynamics model to determine sample prediction state information corresponding to the sample time.

S102

For each sample time, by using the sample prediction state information corresponding to the sample time and the labeled vehicle state information of the sample time, a current loss value corresponding to the initial vehicle dynamics model is determined.

S103

Based on the current loss value, model parameters of the initial vehicle dynamics model are adjusted until the initial vehicle dynamics model reaches a preset convergence state, so as to obtain a pre-constructed vehicle dynamics model.

S104

FIG.1

FIG.2A

FIG.2B

| Historical state information and current control parameter sequence of a target vehicle corresponding to a current time are obtained. | S301 |

| The historical state information and the current control parameter sequence are input into a pre-constructed vehicle dynamics model to determine vehicle state information of the target vehicle at the current time. | S302 |

FIG.3

| 410 | 420 | 430 |
|---|---|---|
| First obtaining module | First determining module | Second determining module |

| 450 | 440 |
|---|---|
| Third determining module | Adjusting module |

FIG.4

| 510 | 520 |
|---|---|
| Third obtaining module | Seventh determining module |

FIG.5

## INTERNATIONAL SEARCH REPORT

International application No.

**PCT/CN2021/109534**

| A. | CLASSIFICATION OF SUBJECT MATTER |
|---|---|

G06F 30/27(2020.01)i

According to International Patent Classification (IPC) or to both national classification and IPC

| B. | FIELDS SEARCHED |
|---|---|

Minimum documentation searched (classification system followed by classification symbols)

G06F 30/-;G06N 3/-;B60W 50/00

Documentation searched other than minimum documentation to the extent that such documents are included in the fields searched

Electronic data base consulted during the international search (name of data base and, where practicable, search terms used)

CNABS; CNTXT; DWPI; SIPOABS; USTXT; CNKI: 车辆, 预测, 模型, 汽车, 历史, 时刻, 训练, 动力学, 运行状态, 控制, 参数, 油门, 刹车, 速度, 加速度, vehicle, prediction, model, automotive, history, time, training, kinetics, operating status, control, parameters, throttle, brakes, speed, acceleration

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | CN 111931286 A (BEIJING BAIDU NETCOM SCIENCE AND TECHNOLOGY CO., LTD.) 13 November 2020 (2020-11-13) description, paragraphs [0004]-[0055], and figure 1 | 1-10 |
| Y | CN 111930015 A (BEIJING SCIENCE AND TECHNOLOGY CO., THREE FAST ONLINE) 13 November 2020 (2020-11-13) description, paragraphs [0002]-[0074], and figures 1-4 | 1-10 |
| Y | CN 111125854 A (BAIDU ONLINE NETWORK TECHNOLOGY (BEIJING) CO., LTD.) 08 May 2020 (2020-05-08) description, paragraphs [0004]-[0101], and figures 1-6 | 1-10 |
| Y | CN 111152796 A (BEIJING SCIENCE AND TECHNOLOGY CO., THREE FAST ONLINE) 15 May 2020 (2020-05-15) description, paragraphs [0002]-[0055], and figures 1-4 | 1-10 |
| A | CN 111626219 A (SHENZHEN HORIZON ROBOTIC TECHNOLOGY CO., LTD.) 04 September 2020 (2020-09-04) entire document | 1-10 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **20 October 2021** | **27 October 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
|---|
| **PCT/CN2021/109534** |

**C.     DOCUMENTS CONSIDERED TO BE RELEVANT**

| Category* | Citation of document, with indication, where appropriate, of the relevant passages | Relevant to claim No. |
|---|---|---|
| A | CN 112238857 A (BEIJING NEW ENERGY VEHICLE TECHNOLOGY INNOVATION CENTER CO., LTD.) 19 January 2021 (2021-01-19)<br>    entire document | 1-10 |
| A | US 2020114926 A1 (TOYOTA MOTOR ENGINEERING & MANUFACTURING NORTH AMERICA INC. et al.) 16 April 2020 (2020-04-16)<br>    entire document | 1-10 |
| PX | CN 112464577 A (MOMENTA (SUZHOU) TECHNOLOGY CO., LTD.) 09 March 2021 (2021-03-09)<br>    entire document | 1-10 |

Form PCT/ISA/210 (second sheet) (January 2015)

## INTERNATIONAL SEARCH REPORT
### Information on patent family members

International application No.

**PCT/CN2021/109534**

| Patent document cited in search report | | | Publication date (day/month/year) | Patent family member(s) | | | Publication date (day/month/year) |
|---|---|---|---|---|---|---|---|
| CN | 111931286 | A | 13 November 2020 | KR | 20210089116 | A | 15 July 2021 |
| CN | 111930015 | A | 13 November 2020 | CN | 111930015 | B | 04 June 2021 |
| CN | 111125854 | A | 08 May 2020 | None | | | |
| CN | 111152796 | A | 15 May 2020 | CN | 111152796 | B | 07 August 2020 |
| CN | 111626219 | A | 04 September 2020 | None | | | |
| CN | 112238857 | A | 19 January 2021 | CN | 112238857 | B | 17 September 2021 |
| US | 2020114926 | A1 | 16 April 2020 | US | 10814881 | B2 | 27 October 2020 |
| | | | | CN | 112638737 | A | 09 April 2021 |
| | | | | WO | 2020081611 | A1 | 23 April 2020 |
| | | | | EP | 3867121 | A1 | 25 August 2021 |
| CN | 112464577 | A | 09 March 2021 | CN | 112464577 | B | 20 April 2021 |

Form PCT/ISA/210 (patent family annex) (January 2015)